# EUROPEAN PATENT APPLICATION

(11) **EP 4 700 419 A1**
(43) Date of publication of application: **25.02.2026**
(21) Application number: 24792325.3
(22) Date of filing: 02.02.2024
(51) Int. Cl.: G01R 33/26, G01N 24/00, G01R 33/20

(54) **DIAMOND SPIN SENSOR AND DEVICE MOUNTED WITH SAME**

(30) Priority: 18.04.2023 JP 2023067531
(71) Applicant: Nissin Electric Co., Ltd., Kyoto-shi, Kyoto 615-8686 (JP); Sumitomo Electric Industries, Ltd., Osaka-shi, Osaka 541-0041 (JP)
(72) Inventor: TATSUMI, Natsuo, Kyoto-shi, Kyoto 615-8686 (JP); HAYASHI, Tsukasa, Kyoto-shi, Kyoto 615-8686 (JP); DEGUCHI, Hiroshige, Kyoto-shi, Kyoto 615-8686 (JP); NISHIBAYASHI, Yoshiki, Osaka-shi, Osaka 541-0041 (JP)
(74) Representative: Boult Wade Tennant LLP
(86) International application number: PCT/JP2024/003394
(87) International publication number: WO 2024/219049

(57) **Abstract**

A diamond spin sensor includes a diamond having a color center with electron spin, and an optical waveguide that transmits excitation light to irradiate the diamond and fluorescence emitted from the diamond, wherein in a state in which the diamond is disposed in an environment where radiation of 1 µGy/h or more is present, a magnetic field, an electric field, or a temperature in the environment is measured using the color center.

## Description

### TECHNICAL FIELD

The present disclosure relates to a diamond spin sensor and a device including the same. This application claims priority based on Japanese Patent Application No. 2023-067531, filed on April 18, 2023, the entire contents of which are hereby incorporated by reference.

### BACKGROUND ART

Sensors that measure magnetic fields, electric fields, current, voltage, temperature, or the like are known. For example, Hall elements or TMR (tunnel magneto resistance) elements are used as sensors for measuring magnetic fields. For example, thermocouples are used as sensors for measuring temperature. These sensors have metal wiring connected to a part that detects a target, and are generally coated with a resin. When such sensors are used in environments where X-rays or electron beams are flying around, ionization caused by X-rays or electron beams produces noise in the metal wiring that transmits electrical signals from the sensor, and the X-rays or electron beams degrade the resin coating. Therefore, those sensors are basically unusable in environments where X-rays or electron beams are flying around.

Diamond spin sensors using NV centers of diamond (hereafter referred to as NV centers) are known as sensors that can be used in environments where X-rays or electron beams are flying around. When the NV center, which consists of a nitrogen atom that substitutes for a carbon atom in diamond and a vacancy adjacent to the nitrogen atom, is negatively charged, its ground state becomes a triplet state (i.e., the spin S is S=1). When excited by a wavelength of 532 nm (i.e., green light), the NV center emits fluorescence at a wavelength of 637 nm (i.e., red light). The intensity of fluorescence emission varies with a spin state. The spin state is changed by magnetic resonance due to a magnetic field applied to the NV center and microwaves or radio waves, and can be used as a magnetic sensor.

For example, a diamond spin sensor includes a diamond substrate containing NV centers, an optical system that transmits excitation light from a light source to irradiate NV centers, an optical system that collects fluorescence from NV centers and transmits the collected fluorescence to a photodetector, and a waveguide that transmits microwaves from a power source to irradiate NV centers. For example, NPL 1 below discloses a configuration in which a diamond sensor is placed on a coplanar waveguide and irradiated with microwaves. The diamond substrate is in the shape of a rectangular parallelepiped. Excitation light is emitted from the side of the diamond substrate, and fluorescence is collected from the top of the diamond substrate.

### CITATION LIST

### NON PATENT LITERATURE

NPL 1: Yuta Masuyama, Yuji Hatano, Takayuki Iwasaki, Mutsuko Hatano, "Highly sensitive macro-scale diamond magnetometer operated with coplanar waveguide resonator", Proceedings of the 79th JSAP (the Japan Society of Applied Physics) Autumn Meeting (publication date: September 5, 2018).
NPL 2: M. W. Doherty, V. M. Acosta, A. Jarmola, M. S. J. Barson, N. B. Manson, D. Budker, and L. C. L. Hollenberg, "Temperature shifts of the resonances of the NV- center in diamond", PHYSICAL REVIEW B 90, 041201(R) (2014).

### SUMMARY OF INVENTION

A diamond spin sensor according to an aspect of the present disclosure includes a diamond having a color center with electron spin, and an optical waveguide that transmits excitation light to irradiate the diamond and fluorescence emitted from the diamond, wherein in a state in which the diamond is disposed in an environment where radiation of 1 µGy/h or more is present, a magnetic field, an electric field, or a temperature in the environment is measured using the color center.

### BRIEF DESCRIPTION OF DRAWINGS

[Fig. 1] Fig. 1 is a schematic diagram showing a configuration of a device using a diamond spin sensor according to a first embodiment.
[Fig. 2] Fig. 2 is a block diagram showing a configuration of the device used in the first embodiment.
[Fig. 3] Fig. 3 is a sequence diagram showing the irradiation timing of excitation light and electromagnetic waves and the measurement timing of emitted light during measurement using the diamond spin sensor shown in Fig. 2.
[Fig. 4] Fig. 4 is a graph schematically showing a relation between the observed signal intensity (i.e., emitted light intensity) and the frequency of electromagnetic waves (i.e., microwaves).
[Fig. 5] Fig. 5 is a schematic diagram showing a configuration of an X-ray generation device using a diamond spin sensor according to a second embodiment.
[Fig. 6] Fig. 6 is a vertical cross-sectional view showing a configuration of an electron beam processing system using a diamond spin sensor according to a third embodiment.
[Fig. 7] Fig. 7 is a vertical cross-sectional view showing a configuration of the diamond spin sensor according to the third embodiment.
[Fig. 8] Fig. 8 is a perspective view showing a configuration of a shielding member.
[Fig. 9] Fig. 9 is a perspective view showing a configuration of the shielding member different from that of Fig. 8.
[Fig. 10] Fig. 10 is a cross-sectional view showing a configuration of a diamond spin sensor according to a fourth embodiment.
[Fig. 11] Fig. 11 is a cross-sectional view showing a configuration of a diamond spin sensor according to a fifth embodiment.

### DETAILED DESCRIPTION

### [Problem to be Solved by the Present Disclosure]

The use of an optical fiber as a waveguide for excitation light and fluorescence prevents the diamond spin sensor from being affected by electrical noise even when used in an environment where X-rays or electron beams are flying around, but the optical waveguide (i.e., optical fiber) may be degraded due to X-rays or electron beams.

Therefore, it is an object of the present disclosure to provide a diamond spin sensor and a device including the same that can be used in an environment where X-rays or electron beams are flying around.

### [Advantageous Effect of the Present Disclosure]

The present disclosure provides a diamond spin sensor and a device including the same that can be used in an environment where X-rays or electron beams are flying around.

### [Description of Embodiments of the Present Disclosure]

The contents of the embodiments of the present disclosure will be described in order. At least some of the embodiments described below may be combined as desired.
(1) A diamond spin sensor according to a first aspect of the present disclosure includes a diamond having a color center with electron spin, and an optical waveguide that transmits excitation light to irradiate the diamond and fluorescence emitted from the diamond, wherein in a state in which the diamond is disposed in an environment where radiation of 1 µGy/h or more is present, a magnetic field, an electric field, or a temperature in the environment is measured using the color center. This configuration can provide a diamond spin sensor and a device including the same that can be used in an environment where X-rays or electron beams are flying around. In other words, this configuration enables measurement in an environment with radiation of 1 µGy/h or more, where conventionally measurement has been difficult.
(2) In (1) above, the diamond spin sensor may further include an excitation light irradiation unit that irradiates the diamond with excitation light and a fluorescence collection unit that collects fluorescence emitted from the diamond, wherein the optical waveguide, the excitation light irradiation unit, and the fluorescence collection unit may be disposed at a location not exposed to radiation. This configuration can suppress degradation of the optical waveguide (e.g., optical fiber) and avoid the excitation light irradiation unit and the fluorescence collection unit from being affected by X-rays or electron beams.
(3) In (2) above, the optical waveguide may be an optical fiber, the diamond spin sensor may further include a metal member that blocks radiation with an energy of a predetermined value or greater, the metal member may cover the optical fiber or be disposed around the optical fiber so that at least the optical fiber is not exposed to radiation of 1 µGy/h or more, and the radiation may include X-rays or electron beams. This configuration can reliably suppress degradation of the optical fiber.
(4) In (3) above, the diamond may be exposed from the metal member. This configuration enables measurement of magnetic fields, electric fields, temperature, and the like with high sensitivity.
(5) In (3) or (4) above, the metal member may include a tubular first shielding part, the optical fiber may have an output end that outputs the excitation light, pass through the first shielding part, and be disposed so that the output end is housed in the first shielding part. This configuration can more reliably suppress degradation of the optical fiber.
(6) In (5) above, the metal member may further include a second shielding part and a third shielding part, and the second shielding part and the third shielding part may be spaced apart from each other with a predetermined spacing and coupled to an end of the first shielding part. With this configuration, a magnetic field formed by charged particles (e.g. electrons) traveling along a direction in which the second and third shielding parts are separated can be measured accurately.
(7) In (6) above, the diamond spin sensor may further include an optical element housed in the first shielding part, the diamond may be disposed at an end opposite to portions of the second and third shielding parts that are coupled to the end of the first shielding part, and the optical element may irradiate the diamond with the excitation light output from the optical fiber. This configuration can reliably prevent the optical fiber from being exposed to radiation and suppress degradation of the optical fiber.
(8) In (7) above, in the first shielding part, the second shielding part, and the third shielding part, a wall surface portion forming a space that houses the diamond and optical element may have a mirror surface. With this configuration, the fluorescence emitted from the diamond can be efficiently input to the optical fiber.
(9) In any one of (5) to (8) above, the diamond spin sensor may further include a reflective member housed in the first shielding part, the diamond may be separated from the reflective member and housed in the first shielding part, and the reflective member may reflect the excitation light output from the optical fiber to irradiate the diamond. This configuration can reliably prevent the optical fiber from being exposed to radiation and suppress degradation of the optical fiber.
(10) In (9) above, in the first shielding part, a wall surface portion forming a space that houses the diamond and the reflective member may have a mirror surface. With this configuration, the fluorescence emitted from the diamond can be efficiently input to the optical fiber.
(11) In any one of (1) to (10) above, an amount of nitrogen in the diamond is 0.5 ppm or more and 300 ppm or less. This configuration can satisfy the required accuracy of physical quantity (magnetic field, electric field, temperature, or the like) to be observed by the diamond spin sensor.
(12) In any one of (1) to (11) above, the excitation light irradiating the diamond has a power density of 10 mW/mm² or more. With this configuration, a sufficient signal-to-noise ratio can be realized in measurement even when electrons are lost from the ground state of the diamond NV center due to radiation of 1 µGy/h or more.
(13) A device according to a second aspect of the present disclosure is a device including the diamond spin sensor according to any one of (2) to (10) above, wherein the optical waveguide, the excitation light irradiation unit, and the fluorescence collection unit are disposed outside an X-ray or electron beam generation device or generation area. This configuration can provide a device including the diamond spin sensor that can be used in an environment where X-rays or electron beams are flying around.
(14) In (13) above, an amount of nitrogen in the diamond is 0.5 ppm or more and 300 ppm or less. This configuration can satisfy the required accuracy of the physical quantity to be observed.
(15) In (13) or (14) above, the excitation light irradiating the diamond has a power density of 10 mW/mm² or more. With this configuration, a sufficient signal-to-noise ratio can be realized in measurement even when electrons are lost from the ground state of the diamond NV center due to radiation of 1 µGy/h or more.
(16) A device according to a third aspect of the present disclosure includes the diamond spin sensor according to any one of (1) to (10) above and uses X-rays or electron beams. This configuration enables measurement of magnetic fields, electric fields, temperature, and the like in an environment where X-rays or electron beams are flying around. In other words, this configuration enables measurement in an environment with radiation of 1 µGy/h or more, where conventionally measurement has been difficult. Similarly, magnetic fields, electric fields, temperature, and the like can be measured in a severe radiation environment with 1 mGy/h or more, even 1 Gy/h or more, even 1 kGy/h or more.

### [Details of Embodiments of the Present Disclosure]

In the following embodiments, like parts are denoted by like reference numbers. Their names and functions are also the same. A detailed description thereof therefore will not be repeated.

### (First Embodiment)

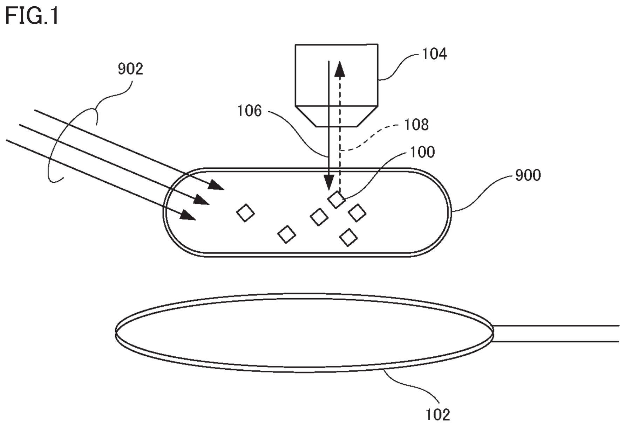

Referring to Fig. 1, a diamond spin sensor according to a first embodiment of the present disclosure includes a diamond 100, an electromagnetic wave irradiation unit 102, and an optical device 104. Diamond 100 is a diamond powder with a particle diameter of 1 to 3 µm including an NV center and is injected into a living cell 900. Living cell 900 is irradiated with radiation 902 from a radiation generation device (not shown) such as an X-ray generation device or an electron beam generation device. The diamond spin sensor is used to observe the effects of radiation on a living body.

Electromagnetic wave irradiation unit 102 irradiates diamond 100 with electromagnetic waves (e.g., microwaves). Electromagnetic wave irradiation unit 102 is, for example, a coil formed by including an electrical conductor. Electromagnetic waves are supplied to electromagnetic wave irradiation unit 102 through a resonator such as a λ/4 open stub made of copper foil and ceramic. Electromagnetic waves are supplied, for example, as an intensity of 1 mW or higher from a microwave generator through a coaxial cable.

Optical device 104 is, for example, a microscope, and irradiates living cell 900 with excitation light 106 transmitted from an electromagnetic wave irradiation unit (e.g., light emitting element) described later, receives fluorescence 108 emitted from diamond 100, and transmits fluorescence 108 to a light detection unit (detection device) described later. For example, diamond 100 is irradiated with excitation light 106 at an intensity of 0.3 mW or higher through optical device 104.

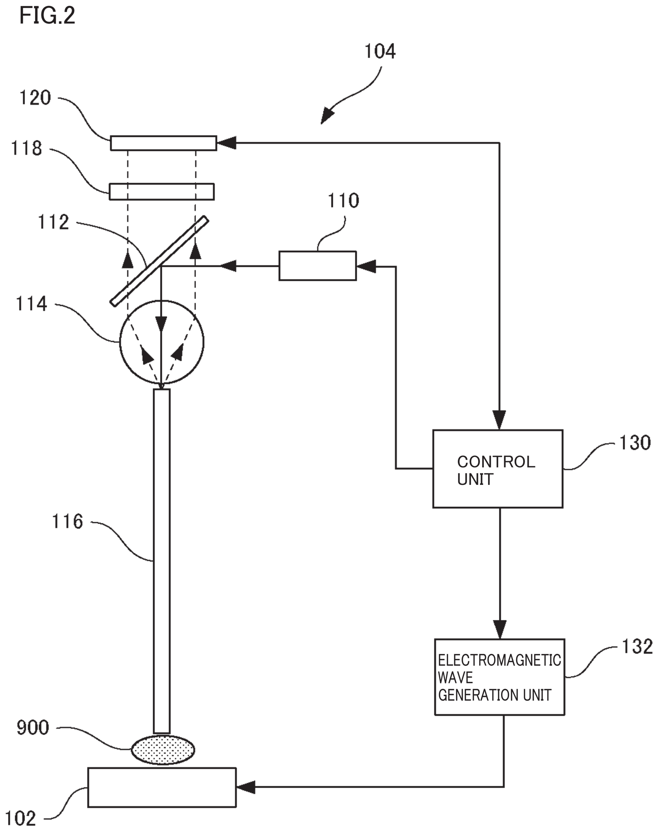

Irradiation of diamond 100 with excitation light 106 and detection of fluorescence 108 emitted from diamond 100 are performed, for example, by a configuration shown in Fig. 2. A control unit 130 includes a central processing unit (CPU) and a storage unit (neither shown). The processing described later that is performed by control unit 130 is implemented by the CPU reading and executing a program stored in advance in the storage unit.

Excitation light generation unit 110 generates excitation light for exciting an NV⁻ center of the diamond (hereinafter referred to as NV center) described later under the control of control unit 130. Control unit 130, for example, supplies excitation light generation unit 110 with a voltage for causing excitation light generation unit 110 to emit light at predetermined timing. The excitation light is green light (i.e., a wavelength of 490 to 560 nm). The excitation light is preferably laser light, and excitation light generation unit 110 is preferably a semiconductor laser (e.g., emitted light with a wavelength of 532 nm). The power density of the excitation light irradiating the diamond NV center (diamond 100) may be 10 mW/mm² or higher. With this configuration, a sufficient signal-to-noise ratio can be realized in measurement even when electrons are lost from the ground state of the diamond NV center due to radiation of 1 µGy/h or more.

A filter 112 is an element for separating the excitation light incident from excitation light generation unit 110 and the light (i.e., fluorescence) emitted from the diamond as described later. For example, filter 112 is a filter that cuts (i.e., reflects) light with a wavelength equal to or shorter than a predetermined wavelength and passes light with a wavelength longer than the predetermined wavelength, or a band-pass filter that passes light with a wavelength within a predetermined wavelength range and cuts (i.e., reflects) light with a wavelength outside the predetermined range. This configuration is preferred because excitation light generally has a shorter wavelength than fluorescence. Filter 112 is preferably a dichroic mirror having such a function.

A light collecting element 114 collects excitation light input from filter 112. Light collecting element 114 is, for example, a spherical lens. Light collecting element 114 inputs the excitation light diffusively output from excitation light generation unit 110 as much as possible to an end of an optical waveguide 116. Optical waveguide 116 includes a medium that transmits light and transmits light in both directions. In other words, optical waveguide 116 has a first end and a second end, and transmits the excitation light incident on the first end to the second end located near living cell 900 containing diamond. Optical waveguide 116 also transmits diamond emitted light (i.e., fluorescence) incident on the second end to the first end and outputs the emitted light. Optical waveguide 116 is, for example, an optical fiber. Although not shown in Fig. 2, the excitation light output from the second end of optical waveguide 116 irradiates living cell 900 via optical device 104 (e.g., microscope) shown in Fig. 1.

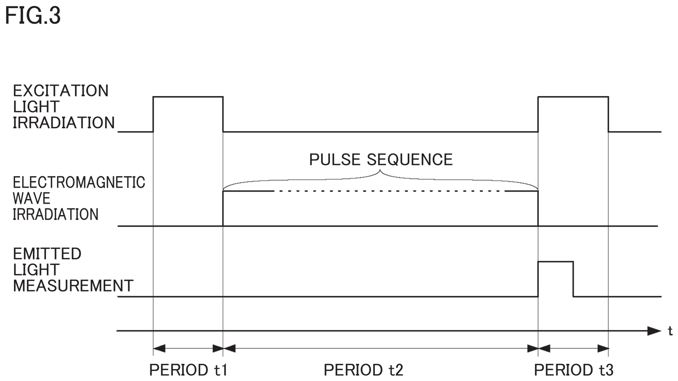

Electromagnetic wave irradiation unit 102 irradiates living cell 900 containing diamond with electromagnetic waves (e.g., microwaves). Electromagnetic wave irradiation unit 102 is, for example, a coil formed by including an electrical conductor. Electromagnetic waves are supplied from an electromagnetic wave generation unit 132 to electromagnetic wave irradiation unit 102, for example, through a coaxial cable. The irradiation of living cell 900 containing diamond with the excitation light and the electromagnetic waves is controlled by control unit 130, for example, at the timing shown in Fig. 3.

Referring to Fig. 3, control unit 130 controls excitation light generation unit 110 to output excitation light for a predetermined period of time (e.g., period t1) at predetermined timing. Control unit 130 controls electromagnetic wave generation unit 132 to output electromagnetic waves for a predetermined period of time (e.g., period t2) at predetermined timing. An appropriate pulse sequence in period t2 may be used as appropriate. With this configuration, the diamond is irradiated with electromagnetic waves in combination in time and space with excitation light. As will be described later, control unit 130 captures an output signal input from a light detection unit 120 at predetermined timing (e.g., within period t3) and stores the output signal in the storage unit.

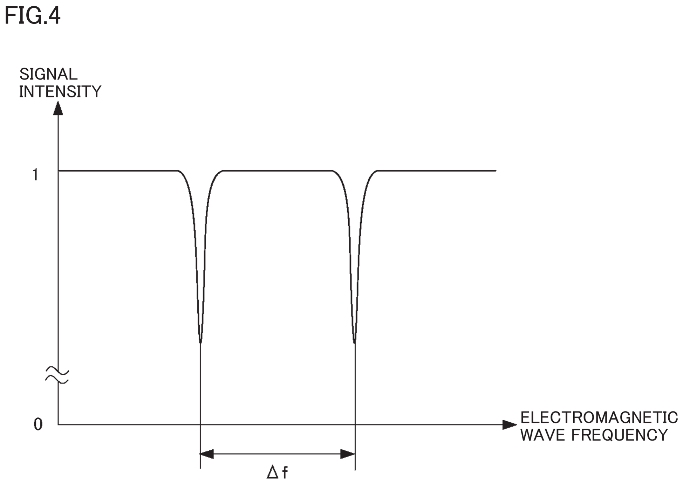

The NV center has a structure in which a carbon (C) atom in a diamond crystal is replaced by a nitrogen (N) atom and a carbon atom that should be present adjacent to the nitrogen atom is absent (i.e., vacancy (V)). The NV center transitions from the ground state to the excited state by green light with a wavelength of 490 nm to 560 nm (e.g., laser light of 532 nm), emits red light with a wavelength of 630 nm to 800 nm (e.g., fluorescence of 637 nm), and returns to the ground state. The NV center forms a spin-triplet state with a magnetic quantum number mₛ of -1, 0, or +1 in a state in which one electron is captured (i.e., NY⁻), and in the presence of a magnetic field, the energy levels of the mₛ=±1 state separate according to the magnetic field strength (i.e. Zeeman separation). The NV center is irradiated with a microwave at 2.87 GHz to induce a transition from the mₛ=0 state to the mₛ=±1 state (i.e., electron spin resonance), and then excited by being irradiated with green light. This results in a decrease in the intensity of the emitted light observed because the transition back to the ground state includes a transition that does not emit light (i.e., fluorescence). Therefore, a valley (i.e., a drop in signal) is observed in an electron spin resonance (ESR) spectrum. As described above, control unit 130 controls excitation light generation unit 110 and electromagnetic wave generation unit 132 so that a spectrum, for example, as shown in Fig. 4 is measured. The observed Δf depends on the magnetic field strength at the location of diamond in living cell 900. Control unit 130 can calculate a magnetic field from Δf.

The fluorescence emitted from diamond 100 in living cell 900 is incident on the second end of optical waveguide 116, transmitted by optical waveguide 116 to the first end and output, and incident on light collecting element 114. Light collecting element 114 expands the narrow fluorescence output from optical waveguide 116 and outputs the expanded fluorescence as collimated light to filter 112. Filter 112 passes the incident fluorescence as described above and allows it to be incident on an LPF 118.

LPF 118 is a long-pass filter and passes light with a wavelength equal to or longer than a predetermined wavelength and cuts (e.g., reflects) light with a wavelength shorter than the predetermined wavelength. Diamond emitted light is red light and passes through LPF 118, but the excitation light output from excitation light generation unit 110 has a shorter wavelength than it and does not pass through LPF 118. This configuration prevents the excitation light emitted from excitation light generation unit 110 from being detected by light detection unit 120 and becoming noise, and reducing the sensitivity of detecting the diamond emitted light (i.e., fluorescence). Light detection unit 120 generates and outputs an electrical signal according to incident light. Light detection unit 120 is, for example, a photodiode. An output signal from light detection unit 120 is acquired by control unit 130.

The nitrogen concentration in the diamond is selected to be 0.5 ppm or more and 300 ppm or less, depending on the required accuracy of physical quantity (magnetic field, electric field, temperature, or the like) to be observed. The amount of nitrogen is preferably 1 ppm or more because radiation such as X-rays reduces the amount of fluorescence from NV⁻ centers.

In the configuration described above, the fluorescence is observed while living cell 900 is irradiated with X-rays at 1 µGy/h or more, for example, X-rays produced by applying an acceleration voltage of 10 kV or higher and an electron beam current of 10 mA or higher to a molybdenum or copper target. For example, a temperature change in a sample containing living cell 900 can be observed around above 1 Gy, and the effects of radiation on a living body can be observed in situ.

In the above, it has been explained that a magnetic field can be calculated from changes in the ESR spectrum. It is known that the resonance frequency of NV centers has a temperature dependence in the range from 120 K to 700 K. For example, as disclosed in NPL 2, temperature can be measured from a frequency change in an optically detected magnetic resonance (ODMR) signal.

Excitation light generation unit 110, filter 112, light collecting element 114, and optical waveguide 116 shown in Fig. 2 constitute an excitation light irradiation unit, and optical waveguide 116, light collecting element 114, filter 112, LPF 118, and light detection unit 120 constitute a fluorescence collection unit. The elements excluding living cell 900 and electromagnetic wave irradiation unit 102 in the configuration shown in Fig. 2 are disposed at locations not irradiated with radiation 902. This configuration can avoid each element used for measurement from being affected by radiation in an environment where radiation such as X-rays or electron beams is flying around, and can suppress degradation of optical waveguide 116.

Since diamond composed of carbon which is a light element has a small reaction cross section with radiation, the NV sensor itself is less affected by radiation and its operation is less disturbed in measurement of magnetic fields or the like with the NV sensor. Radiation may be alpha radiation, beta radiation, neutron radiation, or the like. The radiation dose may be low to the extent that the permeability of the diamond is not reduced (e.g., 500 MGy or less). As described above, magnetic fields, electric fields, temperature, and the like can be measured in an environment with radiation of 1 µGy/h or more, where conventionally measurement has been difficult. Similarly, magnetic fields, electric fields, temperature, and the like can be measured in a severe radiation environment with 1 mGy/h or more, even 1 Gy/h or more, even 1 kGy/h or more.

The coaxial cable for transmitting microwaves to electromagnetic wave irradiation unit 102 is preferably coated with an X-ray damage-resistant material such as alumina, rather than a coaxial cable coated with a resin.

### (Second Embodiment)

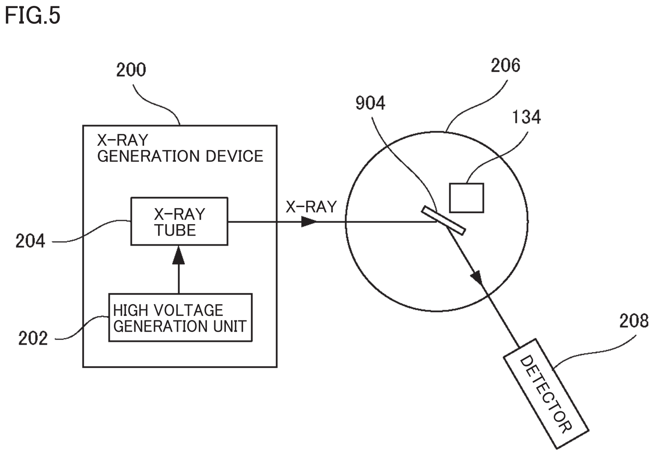

The diamond spin sensor may be mounted on a device that uses radiation. Referring to Fig. 5, the diamond spin sensor according to a second embodiment of the present disclosure is disposed in an X-ray diffraction (XRD) device.

The X-ray diffraction device includes an X-ray generation device 200, a goniometer 206, and a detector 208. X-ray generation device 200 includes a high voltage generation unit 202 and an X-ray tube 204. High voltage generation unit 202 generates a high voltage and supplies the generated high voltage to X-ray tube 204. X-ray tube 204 generates X-rays by accelerating electrons with the high voltage supplied from high voltage generation unit 202 and irradiating a target inside. The generated X-rays irradiate a sample 904 disposed in goniometer 206. Sample 904 is a sample to be measured and is mounted on a sample holder (not shown). A diamond 134 of the diamond spin sensor is disposed, for example, at a location within 10 mm from the sample holder (i.e., near sample 904). Diamond 134 includes NV centers. Unlike diamond 100, diamond 134 is not a powder but a crystal with a predetermined size (e.g., a corner cube with a diagonal length of 1 mm, which will be described later as an example). When sample 904 is irradiated with X-rays, X-rays diffracted in a predetermined direction are emitted due to diffraction caused by the crystal structure of sample 904. Sample 904 is rotated by goniometer 206, and the diffracted X-rays are detected by detector 208.

X-ray tube 204 includes, for example, a molybdenum or copper target, and generates X-rays of 1 µGy/h or more by applying an acceleration voltage of 10 kV or higher and an electron beam current of 10 mA or higher to the target using high voltage generation unit 202.

Although not shown in Fig. 5, the same configuration as in Fig. 2 is used to irradiate diamond 134 instead of living cell 900 with excitation light and microwaves and detect fluorescence emitted from diamond 134. This configuration allows measurement of magnetic fields, electric fields, temperature, or the like generated at the location of diamond 134. For example, changes over time in the magnetic field of sample 904 during X-ray irradiation of sample 904 can be measured.

When diamond 134 is disposed in the X-ray diffraction device as shown in Fig. 5, the elements used in the measurement (i.e., the excitation light irradiation unit, the fluorescence collection unit, control unit 130 that controls them, and the like) are disposed at locations not irradiated with X-rays emitted from X-ray tube 204 and X-rays diffracted by sample 904. This configuration can avoid each element used in the measurement from being affected by X-rays and can suppress degradation of optical waveguide 116 that transmits excitation light and fluorescence.

### (Third Embodiment)

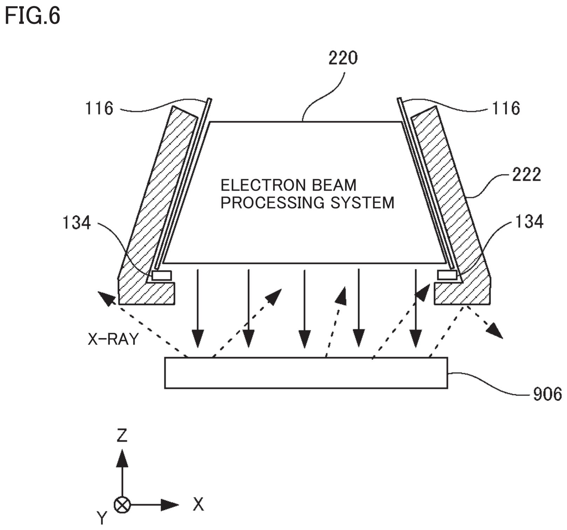

The diamond spin sensor may be mounted on a device that uses charged particles (e.g., electron beams). Referring to Fig. 6, the diamond spin sensor according to a third embodiment of the present disclosure is disposed in an electron beam processing system (EPS).

An electron beam processing system 220 has a shielding member 222 and a rectangular electron beam ejection window (not shown), and outputs electron beams as indicated by downward arrows (Z-axis negative direction) in Fig. 6. The electron beams output from electron beam processing system 220 irradiate a target 906, for example, to modify or improve the quality of target 906. Electron beam processing system 220 is used, for example, to improve the heat resistance of wire coating by applying a cross-linking reaction, to improve the quality of foamed polyethylene, to reduce the weight and improve the quality of automobile tires, or to modify packaging films. Electron beam processing system 220 is also used to disinfect and sterilize medical instruments and the like, or to improve the characteristics of semiconductors.

Diamonds 134 are disposed at locations (e.g., four locations) within 100 mm from ends (e.g., four corners of the rectangle) of the electron beam ejection window of electron beam processing system 220. Although not shown in Fig. 6, the same configuration as in Fig. 2 is used to irradiate each diamond 134 with excitation light and microwaves and detect fluorescence emitted from each diamond 134. Each diamond 134 is irradiated with excitation light transmitted by optical waveguide 116. Fluorescence emitted from diamond 134 is transmitted by optical waveguide 116 to a detection unit.

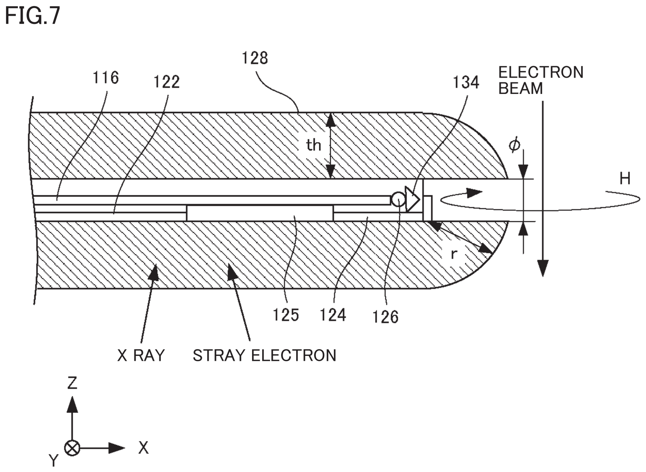

When target 906 is irradiated with electron beams output from electron beam processing system 220, X-rays are emitted from target 906 in random directions as indicated by dashed arrows in Fig. 6, and stray electrons are also generated. Thus, diamonds 134 and optical waveguide 116 may be exposed to X-rays and stray electrons emitted from target 906. To cope with this, the diamond spin sensor according to the third embodiment is configured as shown in Fig. 7. The XYZ axes shown in Fig. 7 correspond to the XYZ axes shown in Fig. 6.

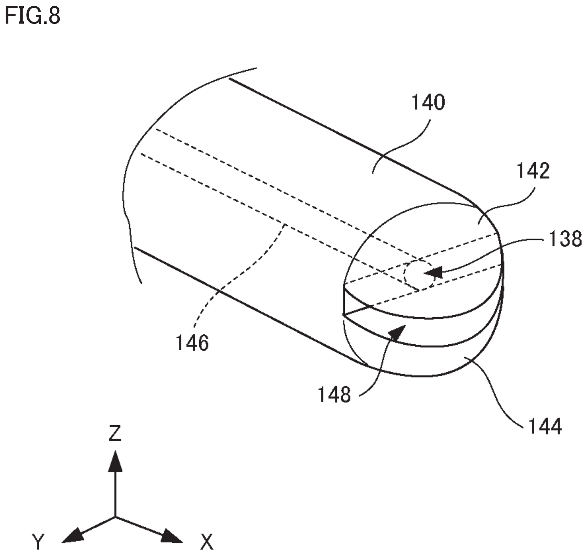

Referring to Fig. 7, the diamond spin sensor includes diamond 134, a light collecting element 126, optical waveguide 116 for transmitting excitation light and fluorescence, a coaxial cable 122 for transmitting microwaves to irradiate diamond 134, an impedance converter 125 and a microwave resonator 124, and a shielding member 128 that houses them. Impedance converter 125 is, for example, a λ/4 transformer, and microwave resonator 124 is, for example, a λ/4 stub. Microwave resonator 124 and impedance converter 125 function as a resonator and increases the magnetic field of microwaves transmitted by coaxial cable 122 to irradiate diamond 134. Referring to Fig. 8, shielding member 128 is formed by combining a first shielding part 140, a second shielding part 142, and a third shielding part 144. The XYZ axes shown in Fig. 8 correspond to the XYZ axes shown in Fig. 7. Shielding member 128 may be formed by individually forming first shielding part 140, second shielding part 142, and third shielding part 144 and then combining them into a single unit, or may be formed as a single unit from the beginning. First shielding part 140 is tubular (e.g., cylindrical) with a thickness th and has an inner wall surface 146. The space enclosed by inner wall surface 146 houses diamond 134, light collecting element 126, optical waveguide 116, coaxial cable 122, impedance converter 125, and microwave resonator 124 shown in Fig. 7. For example, second shielding part 142 and third shielding part 144 are each shaped like a hemisphere with a radius r divided into two equal parts, and are spaced apart from each other with a spacing ϕ in the Z-axis direction. Inner wall surface 146 has an opening 138 with such a size that radiation does not directly impinge on optical waveguide 116 and the like (e.g., as represented by a solid angle centered at light collecting element 126), and diamond 134 is disposed near opening 138 and exposed.

Electron beams emitted from electron beam processing system 220 form a magnetic field H around a direction (i.e., the Z-axis direction) in which electrons travel (i.e., in the XY plane). A gap 148 extends in the XY plane, and a magnetic field formed in gap 148 is not affected by second shielding part 142 and third shielding part 144. As described above, the magnetic field formed in gap 148 is measured by irradiating diamond 134 with excitation light and microwaves and detecting fluorescence emitted from diamond 134. Electromagnetic waves are supplied as an intensity of 3 mW or higher from a microwave generator (not shown) through coaxial cable 122, for example, using a ceramic such as silica glass as an insulator. Excitation light output from excitation light generation unit 110 passes through optical waveguide 116 and irradiates diamond 134 through light collecting element 126, for example, at an intensity of 1 mW or more, preferably 10 mW or more.

Shielding member 128 is formed of a member that blocks radiation (here, X-rays and stray electrons) and suppresses exposure to radiation of diamond 134, optical waveguide 116, light collecting element 126, coaxial cable 122, and microwave resonator 124 housed in the space enclosed by inner wall surface 146. Shielding member 128 is formed of, for example, lead (Pb) or stainless steel (SUS: steel special use stainless). For example, when electron beam processing system 220 has an acceleration voltage of 100 keV and an electron beam current of 100 mA, the thickness th of first shielding part 140 is preferably 2 mm or more. When the acceleration voltage of the electron beam processing system 220 is 300 keV or higher and 500 keV or higher (electron beam current is 100 mA), the thickness th of first shielding part 140 is preferably 5 mm or more and 20 mm or more, respectively.

By disposing the diamond spin sensor configured in this way, it is possible to measure a magnetic field due to the electron beam emitted from the electron beam injection window of electron beam processing system 220, and to calculate a current due to the electron beam from the measured value. By disposing a plurality of diamond spin sensors (for example, disposing them near the four corners of the electron beam injection window), it is possible to measure a distribution of current due to the electron beams. Since shielding member 128 is provided and optical waveguide 116, diamond 134, coaxial cable 122, and light collecting element 126 are housed in the space enclosed by its inner wall surface 146, optical waveguide 116 and the like used in measurement can be avoided from being affected by X-rays and stray electrons produced by irradiation of target 906 with electron beams, and deterioration of optical waveguide 116 and the like that transmits excitation light and fluorescence can be reliably suppressed.

As described above, second shielding part 142 and third shielding part 144 are spaced apart from each other with a spacing ϕ. The opposing surfaces of second shielding part 142 and third shielding part 144 are perpendicular to the direction in which electron beams travel. This configuration can suppress the influence of second shielding part 142 and third shielding part 144 on the magnetic field H formed by the electron beams. Therefore, the magnetic field H formed by the electron beams can be accurately measured.

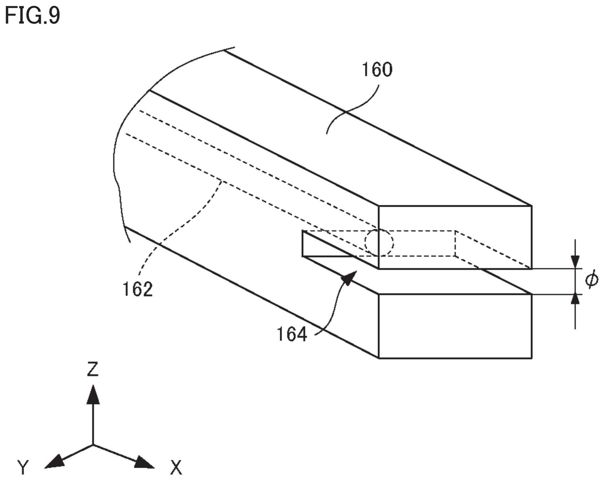

First shielding part 140 is not limited to a cylinder and may be a square prism having inner wall surface 146. Second shielding part 142 and third shielding part 144 are not limited to a hemisphere divided into two equal parts, and may be a rectangular parallelepiped or the like. The second and third shielding parts may be spaced apart from each other with a spacing ϕ. For example, referring to Fig. 9, a member for blocking radiation may include a square prism shielding member 160 with an inner wall surface 162 and a gap 164 having a spacing ϕ. The XYZ axes shown in Fig. 9 correspond to the XYZ axes shown in Fig. 8. The space enclosed by inner wall surface 162 houses diamond 134, light collecting element 126, optical waveguide 116, coaxial cable 122, and microwave resonator 124 shown in Fig. 7.

Electromagnetic waves may be supplied as an intensity of 50 mW or higher from a microwave generator through a coaxial cable, for example, using a ceramic such as silica glass as an insulator. Various pulse sequences can be used for electromagnetic wave irradiation. For example, a pulse sequence can be used for measuring a free induction decay (FID) signal as a magnetic resonance signal or a spin-echo signal by the Hahn echo method.

Pulsed excitation light may be generated from excitation light generation unit 110 by an acoustic optical modulator (AOM) or electrical modulation to read phase information of the electron spin state of diamond 134. The pulsed excitation light is transmitted through optical waveguide 116 to irradiate diamond 134, and the phase information of the electron spin state of diamond 134 can be read by observing the fluorescence.

### (Fourth Embodiment)

When magnetic fields and the like are measured with high sensitivity, it is preferable that the diamond is completely exposed from the shielding. The diamond spin sensor according to a fourth embodiment of the present disclosure is configured in the same manner as in the third embodiment, but the diamond is disposed at a location exposed to radiation. The diamond spin sensor according to the present embodiment may be mounted on a device that uses electron beams (e.g., electron beam processing system) as in the third embodiment.

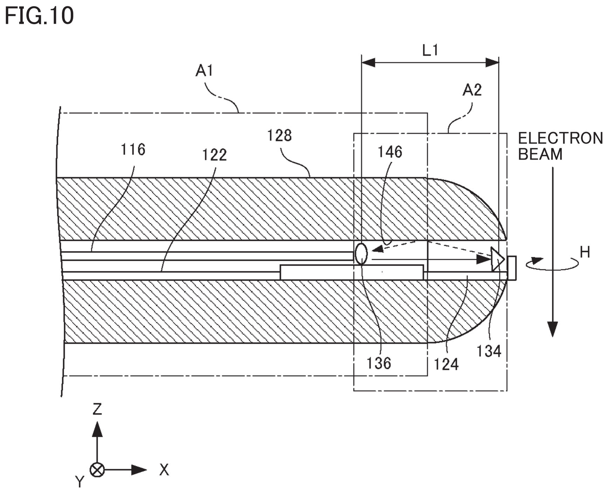

Referring to Fig. 10, the diamond spin sensor according to the present embodiment includes diamond 134, an optical element 136, optical waveguide 116 for transmitting excitation light and fluorescence, coaxial cable 122 and microwave resonator 124 for transmitting microwaves and irradiating diamond 134, and shielding member 128 that houses them. Shielding member 128 is formed as shown in Fig. 8. A section denoted by range A1 corresponds to first shielding part 140 shown in Fig. 8. The space enclosed by inner wall surface 146 houses optical waveguide 116, coaxial cable 122, and optical element 136. Diamond 134 and microwave resonator 124 are disposed outside of inner wall surface 146.

Optical element 136 is, for example, a telephoto lens. Optical element 136 is separated from diamond 134 by a distance L1 and collects the excitation light transmitted by optical waveguide 116 and output from the second end on diamond 134. With this configuration, diamond 134 disposed outside of inner wall surface 146 can be irradiated with excitation light while optical waveguide 116 remains enclosed by inner wall surface 146.

In shielding member 128, a section of range A2, that is, a wall surface (including a portion of inner wall surface 146) that defines the space housing diamond 134, microwave resonator 124, and optical element 136, is formed into a mirror surface by metal deposition or polishing. Fluorescence emitted from diamond 134 is reflected by the mirror surface-like wall surface and collected, and is incident on optical waveguide 116 through optical element 136.

When the diamond spin sensor configured in this way is disposed in electron beam processing system 220, the current and its distribution due to the electron beams emitted from the electron beam injection window of electron beam processing system 220 can be measured. Since shielding member 128 is provided and optical waveguide 116 and coaxial cable 122 are housed in the space enclosed by its inner wall surface 146, optical waveguide 116 and the like used in measurement can be avoided from being exposed to X-rays and stray electrons and being affected by them. Therefore, degradation of optical waveguide 116 and the like that transmits excitation light and fluorescence can be reliably suppressed. Furthermore, since optical element 136 is provided, diamond 134 can be disposed outside of inner wall surface 146, so that magnetic fields, electric fields, temperature, and the like can be measured with high sensitivity. Since the wall surface portion (see region A2) that defines the space housing diamond 134, microwave resonator 124, and optical element 136 is formed into a mirror surface, fluorescence emitted from diamond 134 can be efficiently input to optical waveguide 116.

### (Fifth Embodiment)

Under high intensity radiation, it is preferable that the optical waveguide (i.e., optical fiber), which is easily degraded by radiation, is disposed deeper into the shielding member. The diamond spin sensor according to a fifth embodiment of the present disclosure is configured in the same manner as in the third embodiment, but the optical waveguide is disposed deeper into the shielding member against radiation. The diamond spin sensor according to the present embodiment may be mounted on a device that uses electron beams (e.g., electron beam processing system) as in the third embodiment.

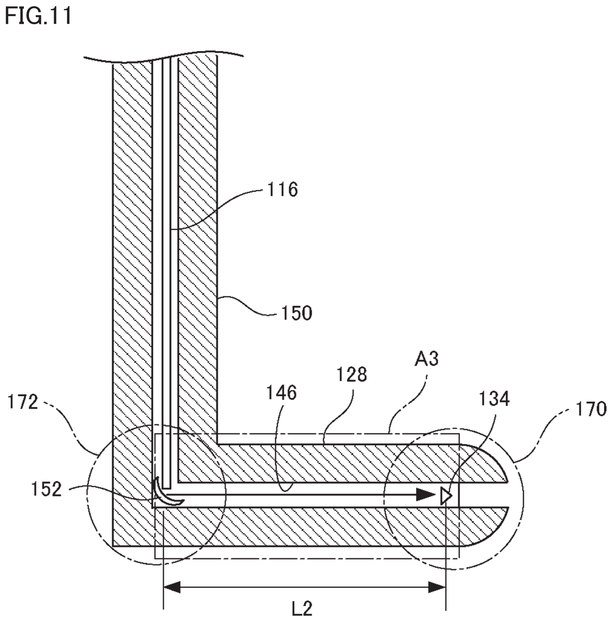

Referring to Fig. 11, the diamond spin sensor according to the present embodiment includes diamond 134, shielding member 128, a fourth shielding part 150, and a reflective member 152. Shielding member 128 is formed as shown in Fig. 8. Fourth shielding part 150 is formed in a tubular shape (e.g., cylindrical shape) in the same manner as first shielding part 140, and its inner wall surface forms a space to house optical waveguide 116 and the like. In Fig. 11, a head part 170 is configured in the same manner as in Fig. 7 (excluding optical waveguide 116 and light collecting element 126). In Fig. 11, coaxial cable 122 and microwave resonator 124 are not shown.

Fourth shielding part 150 is formed of a member that blocks radiation in the same manner as shielding member 128. Optical waveguide 116 is housed in the space defined by the inner wall surface of fourth shielding part 150, and the second end of optical waveguide 116 (i.e., the end that outputs excitation light) is disposed to be located near reflective member 152. Reflective member 152 is a concave mirror (e.g., a mirror surface has a shape that is a part of a parabolic surface). Reflective member 152 is separated from diamond 134 by a distance L2 and is disposed at a joint portion 172 of shielding member 128 and fourth shielding part 150. Excitation light transmitted by optical waveguide 116 and emitted from the second end is reflected by the mirror surface of reflective member 152 and collected on diamond 134.

### Reflective member 152 may be a plane mirror.

Microwaves to irradiate diamond 134 are transmitted by a coaxial cable (not shown) to a microwave resonator (not shown) disposed near diamond 134. The coaxial cable may be disposed so as to pass through the space defined by the inner wall surface of fourth shielding part 150, in the same manner as optical waveguide 116, bend at joint portion 172, pass through the space enclosed by inner wall surface 146, and be connected to the microwave resonator.

It is preferable that inner wall surface 146 is formed into a mirror surface by metal deposition or polishing at region A3. Fluorescence emitted from diamond 134 is reflected by mirror surface-like inner wall surface 146 and collected, incident on the mirror surface of reflective member 152, reflected by the mirror surface, and incident on optical waveguide 116. Fluorescence is transmitted by optical waveguide 116 and detected by a detector (for example, light detection unit 120 in Fig. 2).

When the diamond spin sensor configured in this way is disposed in electron beam processing system 220, the current and its distribution due to the electron beams emitted from the electron beam injection window of electron beam processing system 220 can be measured. Since fourth shielding part 150 is provided to house optical waveguide 116 in its interior space, and reflective member 152 is provided, optical waveguide 116 and the like used in measurement can be avoided from being affected by X-rays and stray electrons, and degradation of optical waveguide 116 and the like that transmits excitation light and fluorescence can be more reliably suppressed. Since the wall surface portion (see region A3) that defines the space housing diamond 134 and reflective member 152 has a mirror surface, fluorescence emitted from diamond 134 can be efficiently input to the optical fiber.

In the above, diamond having NV centers is used as diamond 134. However, the diamond is not limited to this. Any diamond having a color center with electron spin can be used. The color center with electron spin is a center that forms spin triplet states and emits light when excited. NV centers are a typical example of the color center. In addition, color centers with electron spin are known to exist in silicon-vacancy centers (i.e., Si-V centers), germanium-vacancy centers (i.e., Ge-V centers), and tin-vacancy centers (i.e., Sn-V centers). Therefore, a diamond including any of these may be used as diamond 134 to configure a diamond spin sensor.

### [Example 1]

The following example demonstrates the effectiveness of the present disclosure. A diamond spin sensor using a configuration that combines Fig. 2 and Fig. 7 was fabricated and disposed in an electron beam processing system for an experiment.

Diamonds are classified according to the presence or absence of impurities and the type of impurities. In the fabrication of diamond 134, type Ib was used, which contains nitrogen atoms as impurities (that is, having NV centers). This diamond was implanted with electrons with an electron beam acceleration energy of 3 MeV and an electron beam dose of 3×10¹⁸ per cm², and then annealed at 900°C for 1 hour to produce a diamond containing NV centers. This was cut into a shape with a corner cube with a diagonal length of 1 mm to prepare diamond 134.

A head on which the diamond of the diamond spin sensor was disposed was configured as shown in Fig. 7. The thickness th of shielding member 128 was 4 mm. Diamond 134 prepared as described above was irradiated with green light of 5 mW as excitation light. Diamond 134 was irradiated with a microwave by outputting a frequency signal of 3 dBm from a voltage-controlled oscillator (VCO) and sweeping the frequency between 2.74 GHz and 2.94 GHz. The fluorescence intensity was measured during the sweep, and magnetic resonance was observed well even in a radiation environment. With this configuration, an electron beam current of 11 mA emitted from the electron beam processing system with an acceleration voltage of 3 MeV was measured.

The present disclosure has been explained above with description of the embodiments. However, the foregoing embodiments are illustrative and the present disclosure is not limited to the foregoing embodiments. The scope of the present disclosure is indicated by each of the claims in consideration of the detailed description of the invention, and encompasses the meanings equivalent to the wording therein and all changes in the scope.

### REFERENCE SIGNS LIST

100, 134 diamond
102 electromagnetic wave irradiation unit
104 optical device
106 excitation light
108 fluorescence
110 excitation light generation unit
112 filter
114, 126 light collecting element
116 optical waveguide
118 LPF
120 light detection unit
122 coaxial cable
124 microwave resonator
125 impedance converter
128, 160, 222 shielding member
130 control unit
132 electromagnetic wave generation unit
136 optical element
138 opening
140 first shielding part
142 second shielding part
144 third shielding part
146, 162 inner wall surface
148, 164 gap
150 fourth shielding part
152 reflective member
170 head
172 joint portion
200 X-ray generation device
202 high voltage generation unit
204 X-ray tube
206 goniometer
208 detector
220 electron beam processing system
900 living cell
902 radiation
904 sample
906 target
A1, A2, A3 range
L1, L2 distance
r radius
th thickness
ϕ spacing

## Claims

1. A diamond spin sensor comprising:
a diamond having a color center with electron spin; and
an optical waveguide that transmits excitation light to irradiate the diamond and fluorescence emitted from the diamond,
wherein in a state in which the diamond is disposed in an environment where radiation of 1 µGy/h or more is present, a magnetic field, an electric field, or a temperature in the environment is measured using the color center.

2. The diamond spin sensor according to claim 1, further comprising:
an excitation light irradiation unit that irradiates the diamond with the excitation light; and
a fluorescence collection unit that collects fluorescence emitted from the diamond,
wherein the optical waveguide, the excitation light irradiation unit, and the fluorescence collection unit are disposed at a location not exposed to the radiation.

3. The diamond spin sensor according to claim 2, wherein
the optical waveguide is an optical fiber,
the diamond spin sensor further comprises a metal member that blocks radiation with energy of a predetermined value or greater,
the metal member covers the optical fiber or is disposed around the optical fiber so that at least the optical fiber is not exposed to the radiation of 1 µGy/h or more, and
the radiation includes X-rays or electron beams.

4. The diamond spin sensor according to claim 3, wherein the diamond is exposed from the metal member.

5. The diamond spin sensor according to claim 3 or 4, wherein
the metal member includes a tubular first shielding part, and
the optical fiber
has an output end that outputs the excitation light, and
passes through the first shielding part and is disposed such that the output end is housed in the first shielding part.

6. The diamond spin sensor according to claim 5, wherein
the metal member further includes a second shielding part and a third shielding part, and
the second shielding part and the third shielding part are spaced apart from each other with a predetermined spacing and coupled to an end of the first shielding part.

7. The diamond spin sensor according to claim 6, further comprising an optical element housed in the first shielding part, wherein
the diamond is disposed at an end opposite to portions of the second and third shielding parts that are coupled to the end of the first shielding part, and
the optical element irradiates the diamond with the excitation light output from the optical fiber.

8. The diamond spin sensor according to claim 7, wherein in the first shielding part, the second shielding part, and the third shielding part, a wall surface portion forming a space that houses the diamond and the optical element has a mirror surface.

9. The diamond spin sensor according to any one of claims 5 to 8, further comprising a reflective member housed in the first shielding part, wherein
the diamond is separated from the reflective member and housed in the first shielding part, and
the reflective member reflects the excitation light output from the optical fiber to irradiate the diamond.

10. The diamond spin sensor according to claim 9, wherein in the first shielding part, a wall surface portion forming a space that houses the diamond and the reflective member has a mirror surface.

11. The diamond spin sensor according to any one of claims 1 to 10, wherein an amount of nitrogen in the diamond is 0.5 ppm or more and 300 ppm or less.

12. The diamond spin sensor according to any one of claims 1 to 11, wherein the excitation light irradiating the diamond has a power density of 10 mW/mm² or more.

13. A device comprising the diamond spin sensor according to any one of claims 2 to 10,
wherein the excitation light irradiation unit and the fluorescence collection unit are disposed outside an X-ray or electron beam generation device or generation area.

14. The device according to claim 13, wherein an amount of nitrogen in the diamond is 0.5 ppm or more and 300 ppm or less.

15. The device according to claim 13 or 14, wherein the excitation light irradiating the diamond has a power density of 10 mW/mm² or more.

16. A device using X-rays or electron beams, comprising the diamond spin sensor according to any one of claims 1 to 12.
